Europäisches Patentamt

European Patent Office

Office européen des brevets

(19)

(11) **EP 0 991 169 A2**

(12) **EUROPEAN PATENT APPLICATION**

(43) Date of publication:
05.04.2000 Bulletin 2000/14

(51) Int. Cl.$^7$: **H02M 1/12**, H02M 3/156

(21) Application number: **99118864.0**

(22) Date of filing: **24.09.1999**

(84) Designated Contracting States:
**AT BE CH CY DE DK ES FI FR GB GR IE IT LI LU MC NL PT SE**
Designated Extension States:
**AL LT LV MK RO SI**

(30) Priority: **01.10.1998 US 165221**

(71) Applicant: **OSRAM SYLVANIA INC.
Danvers, MA 01923 (US)**

(72) Inventor: **Lester, James N.
Essex, MA 01929 (US)**

(74) Representative: **Pokorny, Gerd
OSRAM GmbH,
Hellabrunner Strasse 1
81543 München (DE)**

(54) **Wave shaping circuit**

(57) A wave shaping circuit is provided having an input node, an output node and a ground node. A first circuit is connected between the input and ground nodes, and a second circuit is connected between the output and ground nodes. The circuits operate so that in a first mode, such as at low RMS line voltage, a V1 signal passes through the wave shaping circuit without being modified as to shape. In a second mode, such as at high RMS line voltage, the line voltage signals are modified to provide flattening of the peak of a waveform provided at the output node.

FIG. 4

**Description**

TECHNICAL FIELD

The present invention relates to a wave shaping circuit for controlling the power line current wave shape into a power supply, or lamp ballast, having input power factor correction circuitry. A method for controlling power line current wave shape in such applications is also provided.

BACKGROUND ART

Until recently, electronic circuits having input AC to DC power conversion tended to draw spikes of current from the power line as the main filter capacitors in such circuits were charged every half cycle. For example, radios, televisions, computers and other electronic products used this type of an input. Typically, power companies prefer simple resistive loads to be connected to the power line. High peak currents are undesirable since they tend to trip circuit breakers and confuse any voltage regulating circuitry. Current pulses generate harmonics which show up on the neutral line of conventional three phase "Y" configured power systems. Normally, power companies will balance the currents in the three phases so that there is little or no neutral current. Such an approach allows the power companies to use small wires for the neutral line and heavy wires for the power lines. Some neutral current harmonics from pulsed current waveforms will add up, the result being a certain level of neutral current. When one or two electronic products are used on a given power line, their affect tends to be insignificant in comparison to the many other resistive loads on the line, and the power companies can therefore ignore such loads.

Presently, many products containing electronic circuits having input AC to DC power conversion are being connected to the power lines. For example, incandescent lamps are being replaced by fluorescent lamps that use such electronic power conversion. The problem is compounded in that many modern industrial buildings have thousands of such electronically powered fluorescent lamps. The result has been that the power companies have had problems with poor line current waveforms. In Europe, laws have been passed to limit the harmonic distortion in line current waveforms. In the United States, voluntary standards have been established, and the power companies presently advertise lists of acceptable products, rebates being offered to provide incentives to those who use such products or otherwise are able to conform their line current waveforms to the applicable standards.

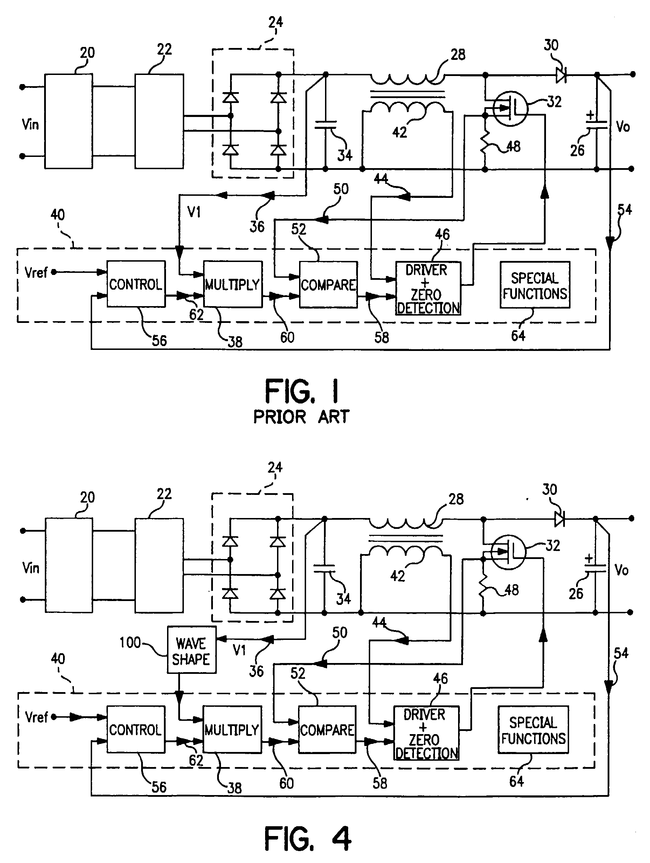

Numerous attempts have been made to modify electronic circuits having input AC to DC converters to produce sinusoidal line currents. One popular approach is illustrated in Fig. 1 which is an example of an integrated control circuit which is presently in its second generation of development and which functions as an input correction circuit as described herein. The circuit illustrated in Fig. 1 is popular because it can be implemented at low cost and occupies a small amount of printed circuit board space. The control circuits are based upon a small 8 pin integrated circuit shown in a simplified form in Fig. 1. Presently, tens of millions of these control circuits are sold each year for use in many types of electronic products including, for example, low cost compact fluorescent integrated and separate lamp ballast lighting packages and higher powered electrodeless fluorescent ballasts. The circuit illustrated in Fig. 1 is known in the industry as a "zero current switching" or "constant ON time switching" curcuit.

The control integrated circuit of Fig. 1 is useful in maintaining constant output voltage while controlling the input current waveform so that it resembles a sine wave. In operation, AC input voltage (Vin) from a power line passes through over-voltage/current protection circuitry 20, and an electrical interference filter 22, to a full wave diode bridge rectifier 24. The line-voltage is converted to half wave rectified DC voltage by rectifier 24. Normally, the voltage across output voltage filter capacitor 26 is greater than the peak voltage out of the rectifier 24, and therefore no current flows in inductor 28 or diode 30 if the switch 32 is off. However, when switch 32 turns on, current will be drawn from the power line via the rectifier 24 and inductor 28 and through switch 32. When switch 32 turns off, the inductor 28 will discharge through the diode 30 into the output filter capacitor 26.

It should be noted that the voltage across inductor 28 is represented by the equation $V=L(di/dt)$ which can be rewritten $di=V(dt/L)$ . If the ON time (dt) is kept constant, the change in line current (di) will be proportional to the instantaneous value of the line voltage. The current in the inductor 28 will always charge from and discharge to O amperes. Therefore, the peak value of the line current will be proportional to the instantaneous value of the line voltage. A sine wave of line voltage results in a sine wave of line current so long as the circuit operates at a frequency much greater than the frequency of the line voltage. For example, the sine wave of the line voltage will result in a sine wave of line current when the circuit operates at frequencies of 10s to 100s of kHz and the frequency of line voltage is 50/60 Hz.

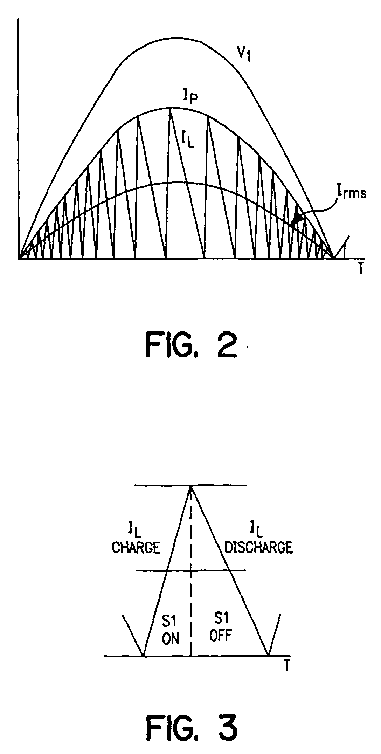

Figs. 2 and 3 illustrate examples of circuit voltage and current waveforms. The triangular waveform of current depicted in Fig. 2, and the enlarged portion thereof depicted in Fig. 3, illustrate the linear nature of charges and discharges of the inductor 28.

The inductor 28 charges from the power line and discharges from the power line into the output filter capacitor 26 and any load connected to the circuit. The charging, or ON time, is constant and the discharging time is dependent upon the load connected to Vo. The peaks of the waveform will scribe a sine wave which is proportional to the shape of the line voltage. The average current is 1/2 the scribed peaks, and the circuit adjusts the ON time to regulate Vo such that the average current is represented by the equation Iin = Po/Vin .

The fully rectified line voltage V1 appears across capacitor 34 and provides an input 36 to the multiplier 38 of the integrated control circuit 40. In this manner, the waveform of the fully rectified line voltage V1 is used by the integrated control circuit to program the current waveform. A winding 42 couples to the inductor 28 and sends a signal 44 to driver and zero detection component 46 of the integrated control circuit 40 to identify when the current in the inductor 28 reaches zero. The peak current in inductor 28 is sensed by resistor 48 when the switch 32 is on, and the corresponding signal 50 is sent to the comparator 52 of the integrated control circuit 40. The output voltage Vo across the output filter capacitor 26 is sensed and the signal 54 is fed to the control circuit 56 of the integrated control circuit 40. The capacitor 34 filters the high frequency current in inductor 28 and keeps it out of the power line, only the average current being seen by the power line.

Switch 32 is turned on when the analog signal 44 from the winding 42 reaches zero and is turned off, when the digital signal 58 from the comparator 52 indicates that the peak current has reached the programmed value. The comparator 52 compares the inductor analog current signal 50 from the resistor 48 to a programmed analog signal 60 from the multiplier 38. The multiplier 38 receives analog sinusoidal signal 36 from the capacitor 34 which is used to program the input current wave shape. Multiplier 38 also receives an analog signal 62 from control circuit 56. The analog signal 62 is proportional to the difference between the output voltage Vo and a fixed DC reference voltage Vref. The ripple on the output voltage V1 comes out of the integrated control circuit 40. The inductor ON time is adjusted to keep Vo constant and the input current sinusoidal by these feedback loops. The circuit of Fig. 1 follows the instantaneous value and shape of line voltage Vin and also follows the RMS value of V1. If the RMS line voltage is doubled, the line current will drop 50% to maintain the proper Vo.

The integrated control circuit 40 contains special internal functions generally designated 64 in Fig. 1. Examples of such functions include over and under voltage shut down and protection, signal filtering, reference voltage Vref, and drive voltage clamping associated with the switch 32.

It should be noted that the integrated control circuit 40 contains no oscillators, and the frequency will vary with the ON and OFF times as illustrated in Figs. 2 and 3. For low RMS line voltage, the RMS current will increase. Since it will take longer to charge the inductor 28 to the higher current value, the operating frequency will decrease. The opposite effect occurs for high RMS line voltage. At a given RMS line voltage the operating frequency will vary with the phase angle of the line voltage, and it will take less ON time for the current in the inductor 28 to reach the proper current near the zero crossings of the line current than at the peaks. Therefore, the operating frequency will be highest near the zero crossings.

Although the integrated control circuit 40 of Fig. 1 is useful in modifying electronic circuits with input AC to DC converters to produce sinusoidal line currents in those applications at a single power line voltage Vin, several problems occur when the power line voltage is varied over a wide range. Such problems tend to degrade the input current wave shape from the desired sine wave. For example, the filtering in the integrated control circuit works best with a constant current in inductor 28. However, the optimal value of the current in the inductor 28 will vary with line voltage. If the inductor current is too large, it may not be possible to achieve the necessary peak current at low line voltage. If inductor current is too small, the frequency at high line voltage may go too high and circuit parasitic effects will begin to have an adverse effect. The value of the inductor current will vary with the level of magnetic flux in its core which will vary with the peak current.

Another problem is that the integrated control circuit 40 does not program the peak current of inductor 28 to equal the instantaneous value of the line current. To the contrary, the integrated control circuit 40 programs the peak inductor current to equal twice the instantaneous value of the line current. Capacitor 34 filters this doubled ripple current so that the average appears on the line.

Yet another problem is that normally the output voltage must be greater than peak line voltage. If the output voltage is less, the integrated control circuit will stop working since Vo will exceed the reference voltage Vref and the line current wave shape will be lost. The larger this difference, the better the circuit will work. It is usual for there to be a minimum difference of at least 30 Vpeak. For example, for a low line voltage such as a 120 VAC line it is not unusual to have an output voltage of 350 VDC and a peak line voltage of 160 Vp, a very satisfactory margin thereby being provided. However, for high line voltages of, for example, 277 VAC, a large margin would mean the presence of very high circuit voltages and the use of expensive parts. In view of such an undesirable outcome, it is common to keep Vo below 450 VDC to allow the use of common parts. When the line voltage reaches about 260 VAC with Vo at 400 VDC, the integrated control circuit 40 will not easily control the energy stored in inductor 28. In addition, when such voltages are close, the zero crossing signal in the winding 42 becomes small, and the circuit becomes confused and does not turn on the switch 32 at the proper time.

Another concern is that the multiplier 38 in the integrated control circuit 40 is linear in the middle of its range but becomes less linear at the ends of its range which corresponds to the extremes of line voltage. Therefore, for a wide input voltage range, the nonlinear ends must be used, and at high and low line voltages performance will deteriorate.

The foregoing problems cause line current to become more peaked at the peak of each half line cycle at high line voltage. In addition, the integrated control circuit 40 catastrophically fails to control line current wave shape at the extremes of line voltage. Further, the regulation of Vo is adversely affected over a wide input voltage range, especially at the extremes of input voltage.

DISCLOSURE OF THE INVENTION

It is an object of the present invention to provide a wave shaping circuit which improves power line current wave shape.

Another object of the present invention is to provide a wave shaping circuit which improves power line current wave shape into a power supply or lamp ballast having input power factor correction circuitry.

It is another object of the present invention to provide a wave shaping circuit which allows operation over a wider range of input power line voltages than previously obtainable while maintaining a high quality or sinusoidal line current waveform.

It is a further object of the present invention to provide a wave shaping circuit which can be applied to most lamp ballast types such as, without limitation, fluorescent, incandescent, and high intensity discharge lamps, having input power factor correction circuitry.

Yet another object of the present invention is to provide an improved wave shaping circuit which can be applied to many power line operated products that require input power factor correction.

Another object of the present invention is to provide an improved wave shaping circuit which may be applied to products that require a wide range of input voltage variation.

A further object of the present invention is to provide a wave shaping circuit which is useful in improving the performance of a zero current switching circuit over its input voltage range and improving output regulation and extending the useful operating range thereof.

The invention achieves these and other objects by providing a wave shaping circuit which comprises an input node adapted to be electrically connected to line voltage, an output node and a ground node. A first circuit is connected between the input node and the ground node for passage of voltage divided line voltage signals at the output node. The voltage divided line voltage signals are divided by a first fixed factor when the line voltage is below a predetermined threshold. A second circuit is connected between the ground node and the output node for modification of the line voltage signals when the line voltage is at or above the predetermined threshold. Such modification provides flattening of the peak of a waveform provided at the output node.

BRIEF DESCRIPTION OF THE DRAWINGS

This invention may be clearly understood by reference to the attached drawings in which like reference numerals designate like parts and in which:

FIG. 1 is a circuit diagram of prior art lamp ballast and input power factor correction circuitry;

FIG. 2 is a graph which illustrates examples of circuit voltage and current waveforms;

FIG. 3 is an enlargement of a portion of the graph of FIG. 2;

FIG. 4 is a circuit diagram of the lamp ballast and input power factor correction circuitry of FIG. 1 and further illustrative of one use of the wave shaping circuit of the present invention in block diagram form;

FIG. 5 is a circuit diagram of one embodiment of the wave shaping circuit of the present invention;

FIG. 6 is a circuit diagram of another embodiment of the wave shaping circuit of the present invention; and

FIG. 7 is a circuit diagram of yet another embodiment of the wave shaping circuit of the present invention.

MODE FOR CARRYING OUT THE INVENTION

For a better understanding of the present invention, together with other and further objects, advantages and capabilities thereof, reference is made to the following disclosure and appended claims taken in conjunction with the above-described drawings.

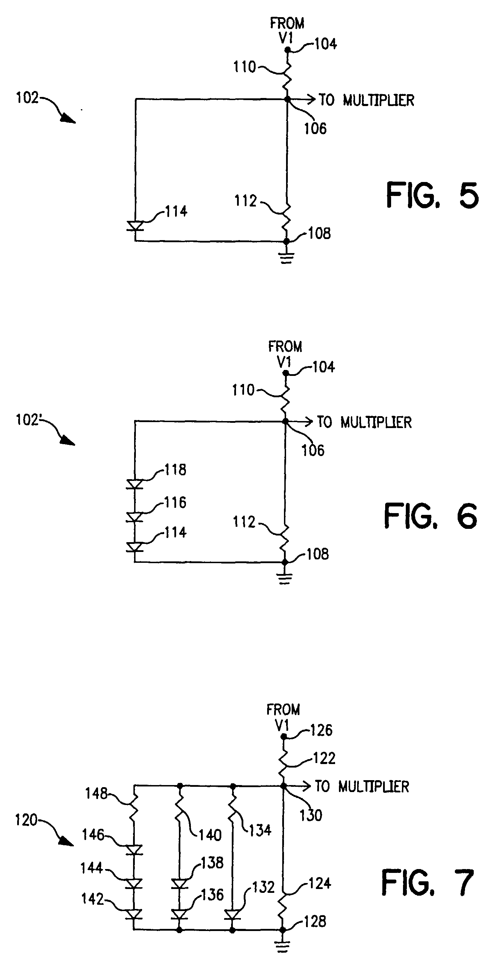

The embodiment of this invention which is illustrated in the drawings is particularly suited for achieving the objects of this invention. Fig. 4 illustrates the circuit of Fig. 1 modified to include the wave shaping circuit of the present invention. In particular, in considering the embodiment of Fig. 4, the rectified sinusoidal signal 36 from the capacitor 34 is passed through a wave shaping circuit 100 of the present invention prior to being connected to the integrated control circuit 40 at an input of multiplier 38. At low RMS line voltage, the signal 36 passes through the wave shaping circuit 100 without being modified. At high RMS line voltage, the peak of the signal 36 is flattened so that the undesired peak in the line current is reduced. As such, the circuit of Fig. 1 is optimized for low line voltage operation and compensated using the wave shaping circuit 100 for acceptable high line voltage performance. In this manner, the wave shaping circuit 100 of the present invention controls the wave shape of the power line current flowing into a power supply, or lamp ballast, having input power factor correction circuitry such as the integrated control circuit 40. To this end, the wave shaping circuit of the present invention includes an input node adapted to be electrically connected to line voltage, an output node and a ground node. A first circuit is connected between the input and ground nodes for passage of voltage divided line voltage signals at the output node, such signals being divided by a first fixed factor when line voltage is below a predetermined threshold. A second circuit is connected between the output and ground nodes for modification of the line voltage signals when line voltage is at or above the predetermined threshold. Such modification provides flattening of the peak of a waveform provided at the output node.

FIG. 5 illustrates one embodiment of the wave shaping circuit of the present invention. In particular, FIG. 5 illustrates a wave shaping circuit 102 which includes an input node 104 adapted to be electrically connected to input 36 of FIG. 4 thereby connecting the input node to rectified line voltage. An output node 106 is provided which is adapted to be electrically connected to an input correction circuit such as the integrated control circuit 40 of FIG. 4. A ground node 108 is also provided. A first circuit is connected between the input node 104 and ground node 108 for passage of voltage divided rectified line voltage signals at the output node 106, such signals being divided by a first fixed factor when line voltage is below a predetermined threshold, as for example, when there is low RMS line voltage. Such division is achieved by providing a first resistive component and a second resistive component in series. For example, in the embodiment of FIG. 5, a first circuit is provided which includes a first resistive component in the form of a resistor 110 and a second resistive component in the form of a resistor 112 in series with resistor 110. The wave shaping circuit 102 also includes a second circuit connected between the output node 106 and ground node 108 for modification of the rectified line voltage signals when line voltage is at or above the predetermined threshold, as for example when there is high RMS line voltage. Such modification provides for flattening of the peak of a waveform provided at the output node 106 and may be achieved by providing a second circuit which comprises at least one switching component electrically connected between the output node 106 and the ground node 108. For example, in the embodiment of FIG. 5, a second circuit is provided which includes a diode 114. Diode 114 is connected in parallel across the resistor 112. Diode 114 functions as a switch to add additional parallel resistance to that already provided by resistor 112. For example, when the wave shaping circuit 100 of FIG. 4 is in the form of the wave shaping circuit 102 of FIG. 5, the voltage divider network formed by resistors 110 and 112 will reduce V1 to less than 2 V peak. Diode 114 is used as a switch to add additional parallel resistance to resistor 112 to modify the voltage divided rectified line voltage if the line voltage is at or above a threshold such as when there is high RMS line voltage.

Depending upon the peak value of V1, additional diode elements may be provided. For example, in the embodiment illustrated in Fig. 6, a wave shaping circuit 102' of the present invention is provided which is identical to the wave shaping circuit 102 of FIG. 5 with the exception that the second circuit connected between the output node 106 and ground node 108 comprises a plurality of switching components. For example, the second circuit of the embodiment illustrated in FIG. 6 includes additional diodes 116 and 118 in series with diode 114, the series connected diodes 114, 116, 118 being connected in parallel across the resistor 112. Like diode 114 of the embodiment of FIG. 5, the diodes 114, 116, 118 function as switches to add additional resistance in parallel to resistor 112 when required; that is, to modify the rectified and divided line voltage if the line voltage is at or above a predetermined threshold. The wave shaping circuits 102 and 102' of Figs. 5 and 6 are useful in applications where minimum fine tuning is required.

Other combinations of resistive elements and switching elements may be provided to further adjust the programming provided by the integrated control circuit 40. For example, the wave shaping circuit of the present invention may comprise a first circuit which includes a voltage divider including a first resistive element and a second resistive element connected in series between an input node and a ground node, and a second circuit which includes first, second and third switching components connected in parallel across the second resistive component. The first, second and third switching components may each comprise at least one diode and at least one resistive element connected in series. For example, Fig. 7 illustrates a wave shaping circuit 120 of the present invention which comprises a first circuit which includes a voltage divider including a first resistive element in the form of resistor 122 and a second resistive element in the form of resistor 124 connected in series between an input node 126 and a ground node 128. The input node 126 is adapted to be electrically connected to rectified line voltage such as at input 36 of FIG. 4. An output node 130 is adapted to be electrically connected to an input correction circuit such as the input correction circuit 40 of FIG. 4. A second circuit is provided which includes a first switching component which comprises a diode 132 connected in series with a resistor 134, the series connected diode 132, resistor 134 being connected in parallel across resistor 124. The second circuit also includes a second switching component which comprises series connected diodes 136, 138 and resistor 140 which are connected in parallel across resistor 124. The second circuit also includes a third switching component which comprises series connected diodes 142, 144, 146 and resistor 148 which are connected in parallel across resistor 124. As in the embodiments of FIGS. 5 and 6, the first circuit, formed by resistors 122 and 124 connected between input node 126 and ground node 128, provide passage of voltage divided rectified line voltage signals at the output node 130, such voltage divided signals divided by a first fixed factor when line voltage is below a predetermined threshold. In this manner, at low RMS line voltage, the V1 signal will pass through the wave shaping circuit without being modified in shape. The second circuit, formed by the remaining resistors and diodes connected between the output node 130 and the ground node 128, provide modification of the rectified line voltage signals when line voltage is above such threshold, the modification providing flattening of the peak of a waveform provided at the output node 130. In this manner, at high RMS line voltage, the peak of the V1 signal will be flattened thereby reducing the peak in the line current.

The wave shaping circuit of Fig. 7 is particularly useful with the integrated control circuit 40 of Fig. 1 wherein the multiplier input voltage is typically limited to less than 2 Vpeak. In such applications, the V1 is hundreds of volts, and the divider network provided by resistors 122 and 124 is useful in reducing V1 to less than 2 Vpeak. The diodes provided in parallel with resistor 124 are used as switches to add additional parallel resistance which serves to further reduce the value of V1. In particular, when the multiplier signal reaches 0.5V, resistor 134 is added in parallel with resistor 124 slightly lowering the resulting equivalent resistance. When the multiplier signal reaches 1.0V, resistor 140 is added in parallel with resistors 124 and 134 further lowering the resulting equivalent resistance. When the multiplier signal reaches 1.5 V, resistor 148 is added in parallel with resistors 124, 134 and 140 further lowering the resulting equivalent resistance.

It will be apparent that in the various embodiments described herein, the values of the resistors can be adjusted to shape the V1 programming signal 36 at several different line voltages or values of V1 thereby providing a means for finely adjusting the line current wave shape as the line voltage is increased. Similarly, in the embodiment of FIG. 7, combinations of series resistors and diodes which form the second circuit can be removed to adjust the programming.

The wave shaping circuit of the present invention improves power line current wave shape. It is particularly useful when applied to a power supply, or a lamp ballast, having input power factor correction circuitry such as, for example, the input correction circuit 40 illustrated in FIG. 4. The wave shaping circuit can be applied to most lamp ballast types such as fluorescent, incandescent and high intensity discharge lamps. It can also be applied to power line operated products. For example, it can be applied to products which include an AC to DC power supply at their input that requires input power factor correction. The wave shaping circuit of the present invention is particularly useful with products that require a wide range of input voltage variation. For example, the wave shaping circuit of the present invention is particularly useful in a universal lamp ballast that can be operated in the United States at 120 VAC or in Europe at 230 VAC. The wave shaping circuit of the present invention allows operation over a wide range of input power line voltages than heretofore obtainable while maintaining a high quality or sinusoidal line current waveform. The wave shaping circuit of the present invention may be modified by merely modifying the combination of resistive and switching components to fine tune the circuit, as desired. The wave shaping circuit of the present invention is useful with first and second generation zero current switching power factor correction integrated circuits including, without limitation, Siemens TDA4862, LinFinity LX1562, LinFinity LX1563, LinFinity SG3561A and SGS L6560 and Samsung Ka7524. The foregoing circuits are simple 8 pin devices. Of course, the wave shaping circuit of the present invention is useful with other PFC control correction circuits.

The embodiments which have been described herein are but some of several which utilize this invention and are set forth here by way of illustration but not of limitation. It is apparent that many other embodiments which will be readily apparent to those skilled in the art may be made without departing materially from the spirit and scope of this invention.

**Claims**

1. A wave shaping circuit, comprising an input node adapted to be electrically connected to line voltage, an output node and a ground node; a first circuit connected between said input node and said ground node for passage of voltage divided line voltage signals at said output node, said voltage divided line voltage signals being divided by a first fixed factor when said line voltage is below a predetermined threshold; and a second circuit connected between said output node and said ground node for modification of said line voltage signals when said line voltage is at or above said predetermined threshold, said modification providing flattening of the peak of a waveform provided at said output node.

2. The wave shaping circuit of claim 1 wherein said first circuit comprises a first resistive component and a second resistive component in series, and further wherein said second circuit comprises at least one switching component connected in parallel across said second resistive component.

3. The wave shaping circuit of claim 2 wherein each switching component comprises at least one diode, and said first and second resistive components comprise a resistor.

4. The wave shaping circuit of claim 3 wherein at least one switching component comprises at least one resistor in series with said at least one diode.

5. The wave shaping circuit of claim 1 wherein said first circuit comprises a first resistive component and a second resistive component in series, and further wherein said second circuit comprises a first switching component, a second switching component and a third switching component, said first, second and third switching components each being connected in parallel across said second resistive component.

6. The wave shaping circuit of claim 5 wherein said first, second and third switching components each comprises at least one diode and at least one resistive element connected in series.

7. The wave shaping circuit of claim 6 wherein each resistive component is a resistor.

8. The wave shaping circuit of claim 7 wherein said first switching component comprises one diode and a first resistor, said second switching component comprises two diodes and a second resistor, and said third switching component comprises three diodes and a third resistor.

9. A wave shaping circuit, comprising an input node adapted to be electrically connected to rectified line voltage, an output node adapted to be electrically connected to an input correction circuit, and a ground node; a first circuit connected between said input node and said ground node for passage of rectified and divided line voltage signals at said output node, said voltage divided rectified line voltage signals being divided by a first fixed factor when line voltage is below a predetermined threshold; and a second circuit connected between said output node and said ground node for modification of said rectified line voltage signals when line voltage is at or above said predetermined threshold, said modification providing flattening of the peak of a waveform provided at said output node.

10. The wave shaping circuit of claim 9 wherein said first circuit comprises a first resistive component and a second resistive component in series, and further wherein said second circuit comprises at least one switching component connected in parallel across said second resistive component.

FIG. I
PRIOR ART

FIG. 4

8

FIG. 2

FIG. 3

FROM
V1 —104
110—
→ TO MULTIPLIER
106
102
114
112
108

FIG. 5

FROM
V1 —104
110—
→ TO MULTIPLIER
106
102'
118
116
114
112
108

FIG. 6

FROM
V1 —126
—122
→ TO MULTIPLIER
130
148
120
146
140 134
144
138
142 136 132 124
128

FIG. 7